# EUROPEAN PATENT APPLICATION

(11) **EP 4 764 565 A1**
(43) Date of publication of application: **24.06.2026**
(21) Application number: 25797850.2
(22) Date of filing: 21.02.2025
(51) Int. Cl.: G01R 31/396, G01R 31/382, G01R 31/392, H02J 7/00

(54) **BATTERY MANAGEMENT DEVICE AND BATTERY MANAGEMENT METHOD**

(30) Priority: 02.05.2024 KR 20240058767
(71) Applicant: LG Energy Solution, Ltd., Seoul 07335 (KR)
(72) Inventor: CHOI, Yean Sik, Daejeon 34122 (KR); LEE, Keun Wook, Daejeon 34122 (KR); LEE, Jung Hoon, Daejeon 34122 (KR); LEE, Byung Kyu, Daejeon 34122 (KR)
(74) Representative: Plasseraud IP
(86) International application number: PCT/KR2025/002456
(87) International publication number: WO 2025/230104

(57) **Abstract**

According to some embodiments, a battery management device includes a data acquisition unit configured to acquire battery data from a multi-pack battery including a main battery pack and one or more sub-battery packs, and a control unit configured to determine whether the multi-pack battery enters a rest mode based on the battery data, select a charge battery pack and a discharge battery pack from the multi-pack battery based on the battery data when entering the rest mode, and perform pack activation for providing power of the discharge battery pack to the charge battery pack.

## Description

### TECHNICAL FIELD

### Cross-reference to Related Applications

This application claims priority from Korean Patent Application No. 10-2024-0058767, filed on May 2, 2024, the disclosure of which is incorporated by reference herein.

### Technical Field

Embodiments disclosed in this document relate to a battery management device and a battery management method.

### BACKGROUND ART

Recently, research and development on secondary batteries have been actively conducted. Here, secondary batteries are batteries that can be charged and discharged, and may be interpreted including both conventional Ni/Cd batteries, Ni/MH batteries, and recent lithium ion batteries. Among secondary batteries, lithium ion batteries may have much higher energy density than conventional Ni/Cd batteries, Ni/MH batteries, etc. and may be manufactured to be small and lightweight, and thus lithium ion batteries may have high usability as a power source for mobile devices. Recently, the scope of use of the lithium ion batteries has expanded to include a power source for electric vehicles, and the lithium ion batteries are attracting attention as a next-generation energy storage medium.

A structure of a multi-pack battery that includes one traction battery pack and one or more extender battery packs may be utilized to provide power for an electric vehicle. In the structure of the multi-pack battery, problems such as long-term non-use or temperature decrease may occur in some of two or more battery packs, which may reduce the lifespan or performance of the entire multi-pack.

### DISCLOSURE OF THE INVENTION

### TECHNICAL PROBLEM

Embodiments disclosed in this document may provide a battery management device and a battery management method that can solve problems caused by long-term non-use or temperature decrease that occurs in some of battery packs in a structure of a multi-pack battery.

The technical objectives of the embodiments disclosed in this document are not limited to the technical problems mentioned above, and other technical problems not mentioned can be clearly understood by those skilled in the art from the descriptions below.

### TECHNICAL SOLUTION

According to some embodiments, a battery management device includes a data acquisition unit configured to acquire battery data from a multi-pack battery including a main battery pack and one or more sub-battery packs, and a control unit configured to determine whether the multi-pack battery enters a rest mode based on the battery data, select a charge battery pack and a discharge battery pack from the multi-pack battery based on the battery data when entering the rest mode, and perform pack activation for providing power of the discharge battery pack to the charge battery pack.

According to some embodiments, the control unit is configured to perform pack selection cycles in which all battery packs of the multi-pack battery are sequentially selected as the charge battery pack and the discharge battery pack, and perform the pack activation for each cycle of the pack selection cycles.

According to some embodiments, the control unit is configured to determine whether a battery charger is connected to the multi-pack battery, and perform the pack selection cycles by treating the battery charger as a battery pack of the multi-pack battery so that the battery charger is selected as the charge battery pack or the discharge battery pack when the battery charger is connected.

According to some embodiments, the control unit is configured to select a battery pack having a lowest state of charge (SOC) among the battery packs of the multi-pack battery as the charge battery pack in a first cycle among the pack selection cycles when the battery charger is not connected, and select the battery charger as the charge battery pack in the first cycle so that the battery charger is selected as the discharge battery pack in a last cycle among the pack selection cycles when the battery charger is connected.

According to some embodiments, the control unit is configured to periodically check whether the battery packs of the multi-pack battery are discharged by a natural discharge and select the charge battery pack based on an artificial discharge when the natural discharge during a reference time section is less than a reference discharge amount.

According to some embodiments, the control unit is configured to select a first battery pack based on a state of charge (SOC), state of health (SOH), and discharge current (C-rate) of each of the battery packs of the multi-pack battery and perform the artificial discharge on the first battery pack.

According to some embodiments, the control unit is configured to repeat the pack activation by additionally performing the pack selection cycles until SOC values of all the battery packs of the multi-pack battery fall within a target SOC range.

According to some embodiments, a battery management method includes acquiring battery data from a multi-pack battery including a main battery pack and one or more sub-battery packs, determining whether the multi-pack battery enters a rest mode based on the battery data, selecting a charge battery pack and a discharge battery pack from the multi-pack battery based on the battery data when entering the rest mode, and performing pack activation for providing power of the discharge battery pack to the charge battery pack.

According to some embodiments, the performing of the pack activation includes performing pack selection cycles in which all battery packs of the multi-pack battery are sequentially selected as the charge battery pack and the discharge battery pack, and performing the pack activation for each cycle of the pack selection cycles.

According to some embodiments, the performing of the pack activation includes determining whether a battery charger is connected to the multi-pack battery and performing the pack selection cycles by treating the battery charger as a battery pack of the multi-pack battery so that the battery charger is selected as the charge battery pack or the discharge battery pack when the battery charger is connected.

According to some embodiments, the selecting of the charge battery pack and the discharge battery pack includes selecting a battery pack having a lowest state of charge (SOC) among the battery packs of the multi-pack battery as the charge battery pack in a first cycle among the pack selection cycles when the battery charger is not connected and selecting the battery charger as the charge battery pack in the first cycle so that the battery charger is selected as the discharge battery pack in a last cycle among the pack selection cycles when the battery charger is connected.

According to some embodiments, the selecting of the charge battery pack and the discharge battery pack includes periodically checking whether the battery packs of the multi-pack battery are discharged by a natural discharge and selecting the charge battery pack based on an artificial discharge when the natural discharge during a reference time section is less than a reference discharge amount.

According to some embodiments, the selecting of the charge battery pack and the discharge battery pack includes selecting a first battery pack based on a state of charge (SOC), state of health (SOH), and discharge current (C-rate) of each of the battery packs of the multi-pack battery and performing the artificial discharge on the first battery pack.

According to some embodiments, the performing of the pack activation includes repeating the pack activation by additionally performing the pack selection cycles until SOC values of all the battery packs of the multi-pack battery fall within a target SOC range.

### ADVANTAGEOUS EFFECTS

According to the embodiments disclosed in this document, a battery management device and a battery management method that can solve problems caused by long-term non-use or temperature decrease in some of the battery packs in the structure of the multi-pack battery can be provided.

Technical effects according to the embodiments disclosed in this document are not limited to the effects mentioned above, and other effects not mentioned will be clearly understood by those skilled in the art according to the disclosure of this document.

### BRIEF DESCRIPTION OF THE DRAWINGS

FIG. 1 illustrates components constituting a battery management system according to some embodiments.
FIG. 2 illustrates components constituting a battery management device according to some embodiments.
FIG. 3 illustrates a structure of a multi-pack battery according to some embodiments.
FIG. 4 illustrates a process of determining whether a multi-pack battery enters a rest mode according to some embodiments.
FIG. 5 illustrates a process of selecting a charge battery pack in a first cycle to perform pack activation according to some embodiments.
FIG. 6 illustrates a method of repeatedly performing pack activation while pack selection cycles are in progress according to some embodiments.
FIG. 7 illustrates steps constituting a battery management method according to some embodiments.

### MODE FOR CARRYING OUT THE INVENTION

Hereinafter, embodiments described in this document are described with reference to the accompanying drawings. However, this is not intended to limit the disclosure of this document to a specific embodiment, but should be understood to include various modifications, equivalents, and/or alternatives of the embodiments described in this document.

Embodiments of this document and the terms used therein are not intended to limit the technical features described in this document to a specific embodiment, but should be understood to include various modifications, equivalents, or alternatives of the embodiment. In connection with the description of the drawings, similar reference numerals may be used for similar or related components. The singular form of a noun corresponding to an item may include one or more of said items, unless the context clearly indicates otherwise.

In this document, each of phrases "A or B", "at least one of A and B", "at least one of A or B", "A, B, or C", "at least one of A, B, and C", and "at least one of A, B, or C" may include any one of the items listed together in that phrase, or all possible combinations thereof. Terms such as "first", "second", "firstly", "secondly", "A", "B", "(a)", or "(b)" may be used merely to distinguish one component from another, and do not limit the components in any other respect (e.g., importance or order) unless specifically stated otherwise.

In this document, when a component (e.g., a first component) is referred to as being "connected", "coupled" or "joined" to another component (e.g., a second component), with or without the terms "functionally" or "communicatively", it means that the component can be connected to the other component directly (e.g., in a wired manner or wirelessly), or indirectly (through a third component).

The method according to various embodiments disclosed in this document may be provided by being included in a computer program product. The computer program product may be traded between a seller and a buyer as a product. The computer program product may be distributed in the form of a machine-readable storage medium (e.g., compact disc read only memory (CD-ROM)), or may be distributed online (e.g., downloaded or uploaded) through an application store or directly between two user devices. In the case of online distribution, at least a part of the computer program product may be temporarily stored or temporarily generated in a machine-readable storage medium such as a memory of a manufacturer's server, an application store's server, a relay server.

According to the embodiments disclosed in this document, each of the components (e.g., modules or programs) described above may include a single or plurality of entities, and some of the plurality of entities may be separated and placed in other components. According to the embodiments disclosed in this document, one or more of the components or operations described above may be omitted, or one or more other components or operations may be added. Alternatively or additionally, a plurality of components (e.g., modules or programs) may be integrated into a single component. In such a case, the integrated component may perform one or more functions of each of the plurality of components identically or similarly to those performed by the corresponding component among the plurality of components prior to the integration. According to the embodiments disclosed in this document, the operations performed by a module, program, or other component may be performed sequentially, in parallel, repeatedly, or heuristically, or one or more of the operations may be performed in a different order, omitted, or performed by being added with one or more other operations.

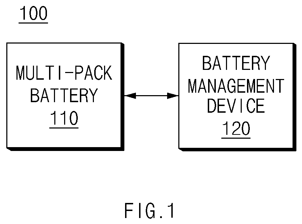

FIG. 1 illustrates components that constitute a battery management system according to some embodiments.

Referring to FIG. 1, a battery management system 100 may include a multi-pack battery 110 and a battery management device 120. However, the present invention is not limited thereto, and some components may be omitted from the battery management system 100, or other general-purpose configurations may be further included in the battery management system 100.

The multi-pack battery 110 may include a plurality of battery packs. The multi-pack battery 110 may include a main battery pack and one or more sub-battery packs. The main battery pack may be a traction battery pack, and the sub-battery pack may be an extender battery pack. The multi-pack battery 110 may be used by a power-using apparatus. The power-using apparatus may include a mobility apparatus such as an electric vehicle (EV), a hybrid electric vehicle (HEV), or an electric bike.

The battery management device 120 can manage a state of the multi-pack battery 110. Some of packs of the multi-pack battery 110 may experience temperature fluctuations or long-term non-use, which may result in degradation of the pack lifespan or pack performance. To prevent this, the battery management device 120 may acquire battery data from the multi-pack battery 110 and perform various management functions based on the acquired battery data.

When the battery pack is left unused for a long time, the performance of the battery pack may degrade and the lifespan thereof may decrease. When only a single battery pack is used, management may be performed internally within the battery pack to resolve the performance degradation. On the other hand, since the multi-pack battery 110 operates two or more battery packs together, it may be possible to cope with performance degradation more flexibly. For example, the battery management system 100 may prevent a non-use state thereof by exchanging power between a plurality of battery packs.

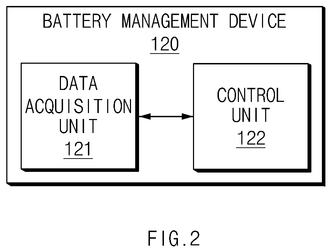

FIG. 2 illustrates components that constitute a battery management device according to some embodiments.

Referring to FIG. 2, the battery management device 120 may include a data acquisition unit 121 and a control unit 122. However, the present invention is not limited thereto, and some configurations may be omitted from the battery management device 120, or other general-purpose configurations may be further included in the battery management device 120.

The data acquisition unit 121 may include a sensor unit and/or a communication unit. The sensor unit may directly measure battery data from the multi-pack battery 110, and the communication unit may receive battery data of the multi-pack battery 110 measured externally from the battery management device 120. For example, when the battery management device 120 is configured together with the multi-pack battery 110 in the form of an on-board BMS, the data acquisition unit 121 may include a sensor unit. Alternatively, when the battery management device 120 is an external device remotely placed in an off-board form of the multi-pack battery 110, the data acquisition unit 121 may include a communication unit. The external device may include a battery charger, a battery management server, etc. According to the embodiment, the battery management server may be implemented in a cloud computing environment.

The control unit 122 may include a memory and/or a processor. The processor may be implemented in the form of at least one of a logic gate array, a microprocessor, a CPU, a GPU, and an AP. The memory may be implemented as a nonvolatile device such as a ROM, a PROM, an EPROM, an EEPROM, a flash memory, a PRAM, a MRAM, a RRAM, a FRAM, etc., or a volatile device such as a DRAM, SRAM, SDRAM, PRAM, etc., and may be implemented in the form of an HDD, an SSD, an SD, a Micro-SD, etc., or a combination thereof.

The data acquisition unit 121 may be configured to acquire battery data from the multi-pack battery 110 including a main battery pack and one or more sub-battery packs. For example, the data acquisition unit 121 may measure battery data directly from the multi-pack battery 110 through the sensor unit, or may receive battery data of the multi-pack battery 110 through the communication unit.

The control unit 122 may be configured to determine whether the multi-pack battery 110 enters a rest mode based on the battery data. Entering into the rest mode may be performed by a user's manual setting, a natural discharge, an artificial discharge, etc. For example, when the multi-pack battery 110 is mounted on a mobility apparatus, whether to enter the rest mode, the time when to enter the rest mode, etc. may be determined based on the time elapsed since the time of parking or ignition off of the mobility apparatus, the state of charge (SOC) values of the battery packs, etc.

The control unit 122 may be configured to select a charge battery pack and a discharge battery pack from the multi-pack battery 110 based on the battery data when entering the rest mode. The charge battery pack may be a battery pack that receives power in power redistribution to resolve an unused state thereof. The discharge battery pack may be a battery pack that provides power for power redistribution. For example, SOC values of the packs of the multi-pack battery 110 may be derived based on the battery data, and the charge battery pack and the discharge battery pack may be selected based on the SOC values.

The control unit 122 may be configured to perform pack activation that provides power of the discharge battery pack to the charge battery pack. The pack activation may resolve the unused state of the multi-pack battery 110 through power transfer. The pack activation may be performed between the selected charge battery pack and discharge battery pack, and other packs of the multi-pack battery 110 may also be sequentially selected as charge battery packs and/or discharge battery packs. For example, all packs of the multi-pack battery 110 may be selected as charge battery packs once and as discharge battery packs once, and in this case, since all packs may perform charging and discharging, the unused state for all packs may be resolved.

According to the embodiment, the control unit 122 may be configured to perform pack selection cycles in which all battery packs of the multi-pack battery 110 are sequentially selected as charge battery packs and discharge battery packs, and to perform pack activation for each cycle of the pack selection cycles. For example, when the multi-pack battery 110 includes one main battery pack and n sub-battery packs, (n + 1) pack selection cycles may be performed, whereby all packs may be selected as a charge battery pack and a discharge battery pack once.

According to the embodiment, the control unit 122 may be configured to determine whether a battery charger is connected to the multi-pack battery 110 and to treat the battery charger as a battery pack of the multi-pack battery 110 and perform pack selection cycles so that the battery charger is selected as the charge battery pack or the discharge battery pack when the battery charger is connected. Since the battery charger may perform charging and discharging, the control unit 122 may perform pack activation in the same manner as for the battery pack of the multi-pack battery 110. The battery charger may operate as the charge battery pack and receive power from the multi-pack battery 110, and then operate as the discharge battery pack to provide the same amount of power to the multi-pack battery 110.

According to the embodiment, the control unit 122 may be configured to select a battery pack having the lowest state of charge (SOC) among the battery packs of the multi-pack battery 110 as a charge battery pack in a first cycle among the pack selection cycles when the battery charger is not connected, and to select the battery charger as a charge battery pack in the first cycle so that the battery charger is selected as a discharge battery pack in the last cycle among the pack selection cycles when the battery charger is connected. When the battery charger is not connected, the battery pack having the lowest SOC may be selected as the charge battery pack in the first cycle so that charging/discharging activation of the battery pack having the lowest SOC may be performed first. When the battery charger is connected, the battery charger may be selected as the charge battery pack in the first cycle to receive power from the battery charger in the last cycle after supplying power to the battery charger in the first cycle.

According to the embodiment, the control unit 122 may be configured to periodically check whether the battery packs of the multi-pack battery 110 are discharged by the natural discharge, and select a charge battery pack based on the artificial discharge when the natural discharge during the reference time section is less than a reference discharge amount. For example, the natural discharge may be checked based on time series battery data measured periodically. When the SOC value of the battery pack is less than a threshold value, it may be determined that the natural discharge has been performed. The threshold value may be SOC 100% and may be changed as needed. Meanwhile, when the natural discharge has not been performed despite the reference time section elapsed, an arbitrary discharge may be performed on some battery packs to manage battery life and performance through pack activation.

According to the embodiment, the control unit 122 may be configured to select a first battery pack based on the state of charge (SOC), state of health (SOH), and discharge current (C-rate) of each of the battery packs of the multi-pack battery 110, and perform the artificial discharge on the first battery pack. For example, a battery pack having the lowest lifespan and/or performance among the battery packs of the multi-pack battery 110 may be subject to the artificial discharge. The lowest lifespan and/or performance may be determined based on indicators such as the SOC, SOH, and C-rate.

According to the embodiment, the control unit 122 may be configured to repeat pack activation by additionally performing pack selection cycles until the SOC values of all the battery packs of the multi-pack battery 110 fall within a target SOC range. The target SOC range may be set to a range suitable for long-term storage of the battery packs. For example, the target SOC range may be a range of SOC 300 or more and 80% or less, and may be changed to a different value depending on the battery pack model or the battery pack storage environment. For example, when the SOC of some battery packs becomes lower than 30%, the battery packs may be set as charge battery packs and pack activation may be performed. Alternatively, when the SOC of some battery packs becomes higher than 80%, the battery packs may be set as discharge battery packs and pack activation may be performed.

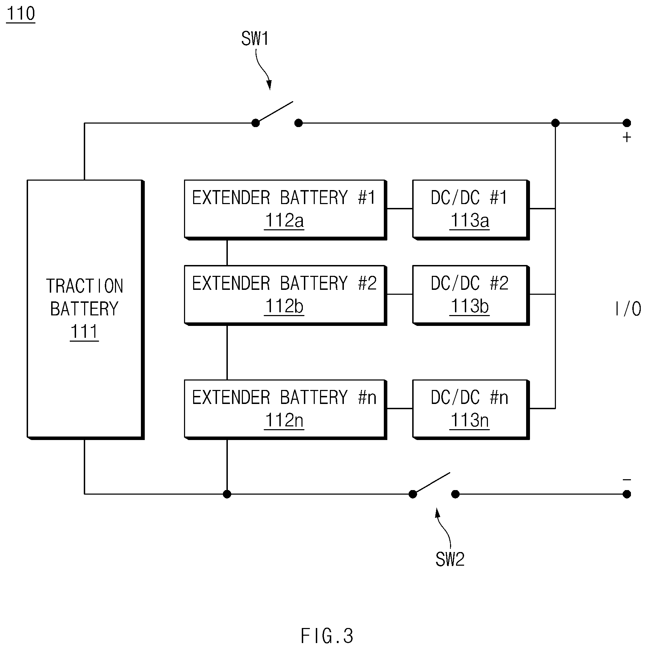

FIG. 3 illustrates a structure of a multi-pack battery according to some embodiments.

Referring to FIG. 3, the multi-pack battery 110 may include a traction battery 111 and one or more extender batteries 112a to 112n. One or more DC-DC converters 113a to 113n may be connected to one or more extender batteries 112a to 112n. The traction battery 111 may correspond to the main battery pack, and one or more extender batteries 112a to 112n may correspond to one or more sub-battery packs.

The control unit of the battery management device 120 and/or the multi-pack battery 110 may control a first switch SW1 and a second switch SW2, etc. to select a battery pack connected to an input/output port I/O. For example, opening and closing of switches of the multi-pack battery 110 may be controlled to transfer power of the discharge battery pack to the charge battery pack.

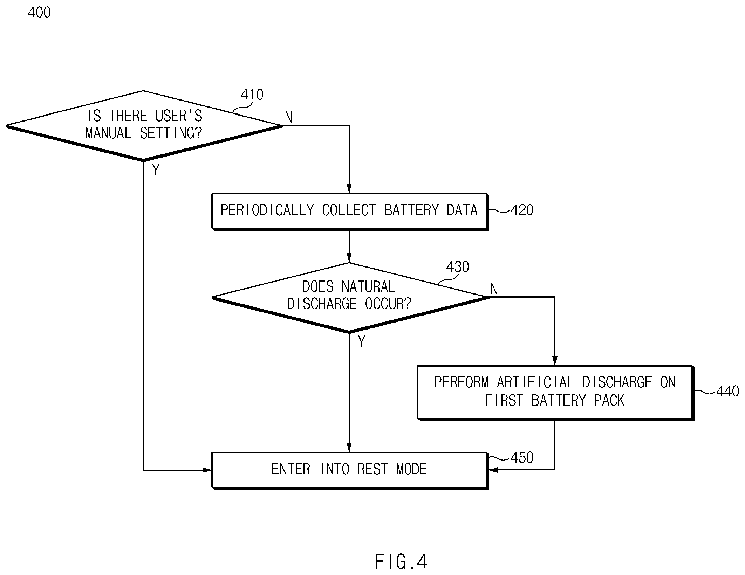

FIG. 4 illustrates a process for determining whether a multi-pack battery enters a rest mode according to some embodiments.

Referring to FIG. 4, a flow 400 illustrating a process for determining whether the multi-pack battery 110 enters the rest mode may be illustrated.

In step 410, it may be checked whether there is a user's manual setting for entering the rest mode. When a user of the multi-pack battery 110 and/or the mobility apparatus manually enters the rest mode through a pre-registered user terminal such as a mobile device, a PC, etc., the rest mode entry may be performed forcibly in step 450. In this case, regardless of whether there is a battery pack having an SOC below a threshold, pack activation may be performed for one or more cycles. When there is no manual setting by the user, battery data may be collected periodically at step 420.

In step 430, it may be determined whether the natural discharge occurs in the multi-pack battery 110. For example, SOC values of the battery packs of the multi-pack battery 110 may be checked periodically. When the natural discharge occurs, entry into the rest mode may be performed in step 450. When the natural discharge does not occur, the artificial discharge may be performed on the first battery pack in step 440, and the first battery pack may be selected based on values such as the SOC, SOH, and C-rate.

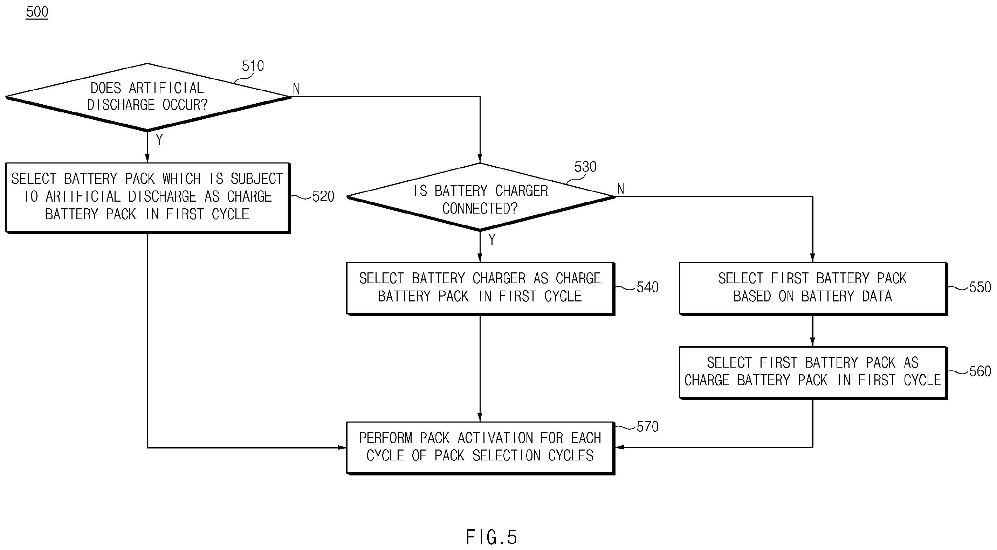

FIG. 5 illustrates a process of selecting a charge battery pack in a first cycle to perform pack activation according to some embodiments.

Referring to FIG. 5, a flow 500 illustrating a process of selecting a charge battery pack in the first cycle to perform pack activation may be illustrated.

In step 510, it may be determined whether the artificial discharge occurs. When the artificial discharge occurs, a battery pack subject to the artificial discharge may be selected as a charge battery pack in the first cycle in step 520, and pack activation may be performed for each cycle in step 570. When the artificial discharge does not occur, it may be determined whether a battery charger is connected in step 530. Meanwhile, cases in which the artificial discharge does not occur may include cases in which the natural discharge occurs and cases in which user manual settings exist.

When the battery charger is connected, the battery charger may be selected as the charge battery pack in the first cycle in step 540, and pack activation may be performed for each cycle in step 570. Considering payment efficiency related to the charging fee, etc., it may be desirable for the battery charger to be selected as the discharge battery pack in the last cycle. To this end, the battery charger may be selected as the charge battery pack in the first cycle. Alternatively, the battery charger may be selected as the charge battery pack and/or the discharge battery pack in any other cycle.

When the battery charger is not connected, a first battery pack may be selected based on time series battery data measured periodically in step 550, and the first battery pack may be selected as the charge battery pack in the first cycle in step 560. Thereafter, pack activation may be performed for each cycle of the pack selection cycles in step 570.

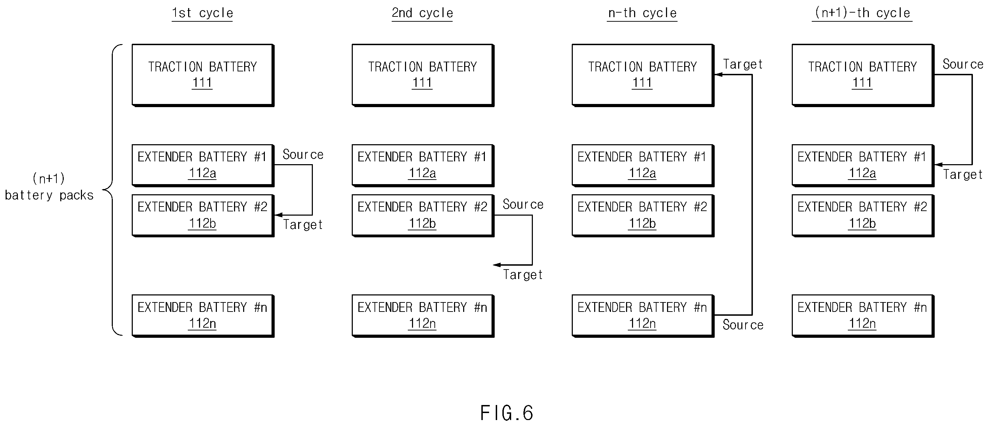

FIG. 6 illustrates a method of repeatedly performing pack activation while pack selection cycles are in progress according to some embodiments.

Referring to FIG. 6, pack selection cycles 600 in which pack activation are repeatedly performed for battery packs of the multi-pack battery 110 may be illustrated.

The multi-pack battery 110 may include one traction battery 111 and n extender batteries 112a to 112n. For (n + 1) battery packs, (n + 1) pack selection cycles 600 may be performed.

In a first cycle, the first extender battery 112a may be selected as a discharge battery pack, and the second extender battery 112b may be selected as a charge battery pack. Thereafter, in a second cycle, the second extender battery 112b may be selected as the discharge battery pack, and a third extender battery may be selected as the charge battery pack. In this sequential manner, (n + 1) pack selection cycles 600 may be performed, and in the last cycle, the first extender battery 112a may be selected as the charge battery pack, and the traction battery 111 may be selected as the discharge battery pack.

Since all battery packs of the multi-pack battery 110 may be sequentially selected as the charge battery pack and the discharge battery pack once, all battery packs may perform charging and discharging. Therefore, the lifespan or performance of the battery pack may be prevented from degrading due to long-term non-use. Meanwhile, when a battery charger is connected, the battery charger may be treated as one battery pack, and (n + 2) pack selection cycles may be performed.

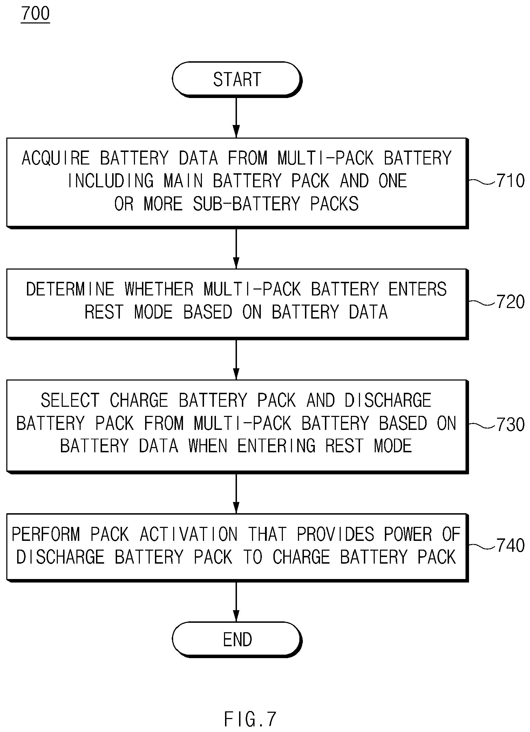

FIG. 7 illustrates steps that constitute a battery management method according to some embodiments.

Referring to FIG. 7, a battery management method 700 may include steps 710 to 740. However, the present invention is not limited thereto, and some steps may be omitted or other general steps may be added, and the steps of the battery management method 700 may be executed in a different order from the illustrated order.

The battery management method 700 may be composed of steps that are processed in time series in the battery management device 120. Therefore, even if the content is omitted below, the content described above for the battery management device 120 may be equally applied to the battery management method 700.

The steps 710 to 740 of the battery management method 700 may be performed by the data acquisition unit 121 and the control unit 122 of the battery management device 120.

In step 710, the battery management device 120 may perform a step of acquiring battery data from a multi-pack battery including a main battery pack and one or more sub-battery packs.

In step 720, the battery management device 120 may perform a step of determining whether the multi-pack battery enters a rest mode based on the battery data.

In step 730, the battery management device 120 may perform a step of selecting a charge battery pack and a discharge battery pack from the multi-pack battery based on the battery data when entering a rest mode.

In step 740, the battery management device 120 may perform a step of performing pack activation that provides power of the discharge battery pack to the charge battery pack.

According to the embodiment, the battery management method 700 may be implemented in the form of a computer program stored in a computer-readable storage medium. That is, the computer program may include instructions for implementing the battery management method 700, and the instructions of the program may be stored in the computer-readable storage medium. The computer program may include a mobile application.

According to the embodiment, the computer-readable storage medium may include magnetic media such as hard disks, floppy disks, and magnetic tapes, optical media such as CD-ROMs, DVDs, magneto-optical media such as floptical disks, and hardware devices specifically configured to store and execute computer program instructions such as ROMs, RAMs, flash memory, etc. The computer program instructions may include machine language codes produced by a compiler and high-level language codes executable by a computer using an interpreter, etc.

The terms "include," "configure," or "have" described above, unless specifically stated to the contrary, mean that the corresponding component may be included, and therefore should be interpreted as further including other components rather than excluding other components. All terms including technical or scientific terms have the same meaning as commonly understood by a person skilled in the art to which the embodiments disclosed in this document belong, unless otherwise defined. Terms commonly used, such as terms defined in the dictionary, should be interpreted as being consistent with the contextual meaning of the relevant technology, and should not be interpreted in an idealized or overly formal sense unless clearly defined in this document.

The above description is merely an illustrative description of the technical idea disclosed in this document, and a person skilled in the art to which the embodiments disclosed in this document belong may make various modifications and variations thereto without departing from the essential characteristics of the embodiments disclosed in this document. Therefore, the embodiments disclosed in this document are not intended to limit the technical idea of the embodiments disclosed in this document, but rather to explain it, and the scope of the technical idea disclosed in this document is not limited by these embodiments. The scope of protection of the technical idea disclosed in this document should be interpreted by the claims below, and all technical ideas within the equivalent scope should be interpreted as being included in the scope of the rights of this document.

### [Description of symbols]

100: battery management system 110: multi-pack battery
120: battery management device 121: data acquisition unit
122: control unit

## Claims

1. A battery management device comprising:
a data acquisition unit configured to acquire battery data from a multi-pack battery including a main battery pack and one or more sub-battery packs; and
a control unit configured to:
determine whether the multi-pack battery enters a rest mode based on the battery data;
select a charge battery pack and a discharge battery pack from the multi-pack battery based on the battery data when entering the rest mode; and
perform pack activation for providing power of the discharge battery pack to the charge battery pack.

2. The battery management device of claim 1, wherein the control unit is configured to:
perform pack selection cycles in which all battery packs of the multi-pack battery are sequentially selected as the charge battery pack and the discharge battery pack; and
perform the pack activation for each cycle of the pack selection cycles.

3. The battery management device of claim 2, wherein the control unit is configured to:
determine whether a battery charger is connected to the multi-pack battery; and
perform the pack selection cycles by treating the battery charger as a battery pack of the multi-pack battery so that the battery charger is selected as the charge battery pack or the discharge battery pack when the battery charger is connected.

4. The battery management device of claim 3, wherein the control unit is configured to:
select a battery pack having a lowest state of charge (SOC) among the battery packs of the multi-pack battery as the charge battery pack in a first cycle among the pack selection cycles when the battery charger is not connected; and
select the battery charger as the charge battery pack in the first cycle so that the battery charger is selected as the discharge battery pack in a last cycle among the pack selection cycles when the battery charger is connected.

5. The battery management device of claim 1, wherein the control unit is configured to:
periodically check whether the battery packs of the multi-pack battery are discharged by a natural discharge; and
select the charge battery pack based on an artificial discharge when the natural discharge during a reference time section is less than a reference discharge amount.

6. The battery management device of claim 5, wherein the control unit is configured to:
select a first battery pack based on a state of charge (SOC), state of health (SOH), and discharge current (C-rate) of each of the battery packs of the multi-pack battery; and
perform the artificial discharge on the first battery pack.

7. The battery management device of claim 2, wherein the control unit is configured to repeat the pack activation by additionally performing the pack selection cycles until SOC values of all the battery packs of the multi-pack battery fall within a target SOC range.

8. A battery management method comprising:
acquiring battery data from a multi-pack battery including a main battery pack and one or more sub-battery packs;
determining whether the multi-pack battery enters a rest mode based on the battery data;
selecting a charge battery pack and a discharge battery pack from the multi-pack battery based on the battery data when entering the rest mode; and
performing pack activation for providing power of the discharge battery pack to the charge battery pack.

9. The battery management method of claim 8, wherein the performing of the pack activation includes:
performing pack selection cycles in which all battery packs of the multi-pack battery are sequentially selected as the charge battery pack and the discharge battery pack; and
performing the pack activation for each cycle of the pack selection cycles.

10. The battery management method of claim 9, wherein the performing of the pack activation includes:
determining whether a battery charger is connected to the multi-pack battery; and
performing the pack selection cycles by treating the battery charger as a battery pack of the multi-pack battery so that the battery charger is selected as the charge battery pack or the discharge battery pack when the battery charger is connected.

11. The battery management method of claim 10, wherein the selecting of the charge battery pack and the discharge battery pack includes:
selecting a battery pack having a lowest state of charge (SOC) among the battery packs of the multi-pack battery as the charge battery pack in a first cycle among the pack selection cycles when the battery charger is not connected; and
selecting the battery charger as the charge battery pack in the first cycle so that the battery charger is selected as the discharge battery pack in a last cycle among the pack selection cycles when the battery charger is connected.

12. The battery management method of claim 8, wherein the selecting of the charge battery pack and the discharge battery pack includes:
periodically checking whether the battery packs of the multi-pack battery are discharged by a natural discharge; and
selecting the charge battery pack based on an artificial discharge when the natural discharge during a reference time section is less than a reference discharge amount.

13. The battery management method of claim 12, wherein the selecting of the charge battery pack and the discharge battery pack includes:
selecting a first battery pack based on a state of charge (SOC), state of health (SOH), and discharge current (C-rate) of each of the battery packs of the multi-pack battery; and
performing the artificial discharge on the first battery pack.

14. The battery management method of claim 9, wherein the performing of the pack activation includes repeating the pack activation by additionally performing the pack selection cycles until SOC values of all the battery packs of the multi-pack battery fall within a target SOC range.
